(19)

Europäisches
Patentamt
European
Patent Office
Office européen
des brevets

(11) **EP 4 715 405 A1**

(12) **EUROPEAN PATENT APPLICATION**
published in accordance with Art. 153(4) EPC

(43) Date of publication:
**25.03.2026 Bulletin 2026/13**

(21) Application number: **23942541.6**

(22) Date of filing: **07.11.2023**

(51) International Patent Classification (IPC):
*G01R 31/367* (2019.01)    *G01R 31/36* (2020.01)
*G01R 31/392* (2019.01)    *G01R 31/396* (2019.01)
*G01R 31/52* (2020.01)

(86) International application number:
**PCT/KR2023/017754**

(87) International publication number:
**WO 2024/262712 (26.12.2024 Gazette 2024/52)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **22.06.2023   KR 20230080445**

(71) Applicant: **LG Energy Solution, Ltd.
Seoul 07335 (KR)**

(72) Inventor: **JEON, Young Hwan
Daejeon 34122 (KR)**

(74) Representative: **Plasseraud IP
104 Rue de Richelieu
CS92104
75080 Paris Cedex 02 (FR)**

(54) **BATTERY DIAGNOSIS DEVICE AND OPERATION METHOD THEREOF**

(57)     A battery diagnosis device according to one embodiment disclosed herein includes an encoder configured to convert time series data on a state of a battery into a latent variable, a decoder configured to convert the latent variable into first reconstruction data in a time domain, a first discriminator configured to discriminate the time series data with the first reconstruction data and output a result of the discrimination, a first calculator configured to compare the time series data with the first reconstruction data and calculate a reconstruction error, a second calculator configured to calculate an anomaly score based on a result of the discrimination and the reconstruction error, and a diagnosis instrument configured to diagnose the anomaly of the battery based on the anomaly score and a critical value.

FIG.1

EP 4 715 405 A1

**Description**

**TECHNICAL FIELD**

CROSS-REFERENCE TO RELATED APPLICATION

This application claims priority to and the benefit of Korean Patent Application No. 10-2023-0080445 filed in the Korean Intellectual Property Office on June 22, 2023, the entire contents of which are incorporated herein by reference.

TECHNICAL FIELD

Embodiments disclosed herein relate to a battery diagnosis device and a method of operating the same.

**BACKGROUND ART**

Recently, research and development on secondary batteries has been actively conducted. Here, the secondary battery is a battery capable of charging and discharging and includes all recent lithium ion batteries such as conventional Ni/Cd batteries and Ni/MH batteries. Among the secondary batteries, the lithium-ion batteries have an advantage of having a much higher energy density than the conventional Ni/Cd batteries, the Ni/MH batteries, and the like. In addition, since the small and light-weight lithium ion batteries may be manufactured, the lithium ion batteries are used as a power source for mobile devices, and recently, the lithium ion batteries are attracting attention as a next-generation energy storage medium due to the expansion of the range of use to a power source for electric vehicles.

In addition, the secondary batteries may generally be used as a battery pack including a battery module in which a plurality of battery cells are connected in series and/or parallel. In addition, the secondary batteries may be used as a battery rack including a plurality of battery modules and a rack frame accommodating the battery modules.

The battery cells, the battery modules, the battery packs, or the battery racks may be used in various devices. For example, the batteries may be used not only in mobile devices such as mobile phones, laptop computers, smart phones, and smart pads, but also in a field such as vehicles (electric vehicles (EV), hybrid electric vehicles (HEV), and plug-in HEVs (PHEV)) driven by electricity or a large power storage device (electric power storage system (ESS)).

States and operations of the batteries may be managed and controlled by a battery management system (BMS). The BMS may be included in one device together with the battery.

In addition, the BMS may manage and control the battery in a state of being spaced apart from the device including the battery. For example, the BMS may be implemented as a separate server device. In this case, the BMS may collect battery data and vehicle data from a vehicle and the like and manage and control the battery using the collected data.

**TECHNICAL PROBLEM**

When a short circuit or other type of failure occurs inside a battery, the possibility of damage to devices (e.g., an electric vehicle (EV) or an electric power storage system (ESS)) including the battery may increase. Therefore, a method for detecting an abnormal state of the battery and reducing the possibility of damage to the devices including the battery is required.

In a conventional long-term cycle test of a battery, a degree of deterioration of the battery or the anomaly of the battery was diagnosed by comparing a pre-test capacity with a post-test capacity. Since the test was performed for a long time of at least 100 cycles, it was difficult for people to continuously check the battery, and since time series data was collected as information including noises of sensors, many misdiagnoses occurred.

Embodiments disclosed herein may provide a battery diagnosis device capable of diagnosing the anomaly of a battery using an artificial intelligence model learning a pattern, which has not been detected previously, as an abnormal pattern in consideration of the instantaneous fluctuation of a battery state value, and a method of operating the same.

The embodiments disclosed herein may provide a battery diagnosis device capable of diagnosing the anomaly of a battery based on the correlation between variables of a battery state by learning not only various variables but also a voltage of the battery as input factors.

The objects of embodiments disclosed herein are not limited to the above-described objects, and other objects that are not mentioned will be able to be clearly understood by those skilled in the art from the following descriptions.

**TECHNICAL SOLUTION**

A battery diagnosis device according to one embodiment disclosed herein includes an encoder configured to convert time series data on a state of a battery into a latent variable, a decoder configured to convert the latent variable into first reconstruction data in a time domain, a first discriminator configured to discriminate the time series data with the first reconstruction data and output a result of the discrimination, a first calculator configured to compare the time series data with the first reconstruction data and calculate a reconstruction error, a second calculator configured to calculate an anomaly score based on a result of the discrimination and the reconstruction error, and a diagnosis instrument configured to diagnose the anomaly of the battery based on the anomaly score and a critical value.

The battery diagnosis device according to one embodiment disclosed herein may further include a second discriminator configured to discriminate the performance of the encoder based on the latent variable and random noise on a latent space.

In the battery diagnosis device according to one embodiment disclosed herein, the decoder may convert the random noise on the latent space into second reconstruction data in the time domain, and the first discriminator may output a result of the discrimination based on a discrimination model learned to discriminate the time series data and the second reconstruction data.

In the battery diagnosis device according to one embodiment disclosed herein, the first calculator may calculate the reconstruction error according to a combined comparison method of comparing the time series data with the first reconstruction data in the entire time section included in the time series data.

In the battery diagnosis device according to one embodiment disclosed herein, the first calculator may calculate the reconstruction error according to a split comparison method of comparing the time series data with the first reconstruction data in a specified partial time section of the entire time section included in the time series data.

In the battery diagnosis device according to one embodiment disclosed herein, the second calculator may calculate the anomaly score based on Equation 1 below,

[Equation 1]

$$Anomaly\ Score = \alpha \times Z_{reconstruction} + (1-\alpha) \times Z_{Cx}$$

(in Equation 1, $\alpha$ denotes a weight, $Z_{reconstruction}$ denotes the reconstruction error, and $Z_{Cx}$ denotes a result of the discrimination.).

In the battery diagnosis device according to one embodiment disclosed herein, the second calculator may calculate the anomaly score based on Equation 2 below,

[Equation 2]

$$Anomaly\ Score = \alpha \times Z_{reconstruction}) \times Z_{Cx}$$

(in Equation 2, $\alpha$ denotes a weight, $Z_{reconstruction}$ denotes the reconstruction error, and $Z_{Cx}$ denotes a result of the discrimination.).

In the battery diagnosis device according to one embodiment disclosed herein, the diagnosis instrument may increase the critical value, compare the anomaly score with the critical value, and diagnose the anomaly of the battery, and determine an optimal critical value based on all critical values used when diagnosing the anomaly of the battery when the critical value is larger than or equal to a specified value.

In the battery diagnosis device according to one embodiment disclosed herein, the diagnosis instrument may calculate area under ROC curve (AUROC) values corresponding to the all critical values, and determine a critical value corresponding to a maximum AUROC value among the AUROC values to be an optimal critical value.

In the battery diagnosis device according to one embodiment disclosed herein, a battery diagnosis method includes an operation of converting time series data on a state of a battery into a latent variable, an operation of converting the latent variable into first reconstruction data in a time domain, an operation of discriminating the time series data with the first reconstruction data and calculating a result of the discrimination, an operation of comparing the time series data with the first reconstruction data and calculating a reconstruction error, an operation of calculating an anomaly score based on a result of the discrimination and the reconstruction error, and an operation of diagnosing the anomaly of the battery based on the anomaly score and a critical value.

The battery diagnosis method according to one embodiment disclosed herein may further include an operation of converting random noise on a latent space into second reconstruction data in a time domain, wherein the operation of discriminating a result of the discrimination may include an operation of calculating a result of the discrimination based on a discrimination model learned to discriminate the time series data and the second reconstruction data.

In the battery diagnosis method according to one embodiment disclosed herein, the operation of calculating the reconstruction error may include an operation of calculating the reconstruction error according to a combined comparison method of comparing the time series data with the first reconstruction data in the entire time section included in the time series data.

In the battery diagnosis method according to one embodiment disclosed herein, the operation of calculating the reconstruction error may include an operation of calculating the reconstruction error according to a split comparison method of comparing the time series data with the first reconstruction data in a specified partial time section of the entire time section included in the time series data.

The battery diagnosis method according to one embodiment disclosed herein may further include an operation of increasing the critical value, comparing the anomaly score with the critical value, and diagnosing the anomaly of the battery, and an operation of determining an optimal critical value based on all critical values used when diagnosing the anomaly of the battery when the critical value is larger than or equal to a specified value.

In the battery diagnosis method according to one embodiment disclosed herein,
the operation of determining the optimal critical value may include an operation of calculating area under ROC curve (AUROC) values corresponding to the all critical values, and an operation of determining a critical value corresponding to a maximum AUROC value among the AUROC values to be an optimal critical value.

## ADVANTAGEOUS EFFECTS

According to the embodiments disclosed herein, it is possible to reduce the manpower and the time required for diagnosing the anomaly of the battery.

According to the embodiments disclosed herein, it is possible to reduce the compensation cost occurring in the field by detecting the abnormal pattern of the battery, which has not been detected previously.

In addition, various effects that may be directly or indirectly identified through this document can be provided.

## DESCRIPTION OF DRAWINGS

FIG. 1 is a block diagram of a battery diagnosis device according to one embodiment.
FIG. 2 is a view illustrating a battery diagnosis system according to one embodiment.
FIG. 3 is a view for describing various examples in which the battery diagnosis system according to one embodiment calculates a reconstruction error.
FIG. 4 is an operation flowchart of the battery diagnosis device according to one embodiment.
FIG. 5 is an operation flowchart of the battery diagnosis device according to one embodiment.
FIG. 6 is an operation flowchart of the battery diagnosis device according to one embodiment.

## Mode for Invention

Hereinafter, various embodiments of the present invention will be described with reference to the accompanying drawings. However, it should be understood that this is not intended to limit the present invention to specific embodiments and includes various modifications, equivalents, and/or alternatives of the embodiments of the present invention.

It should be understood that various embodiments of this document and the terms used therein are not intended to limit the technical features described herein to specific embodiments and include various modifications, equivalents, or substitutes of the corresponding embodiments. In the description of the drawings, similar reference numerals may be used for similar or related components. The singular form of a noun corresponding to an item may include one item or a plurality of items unless the relevant context clearly dictates otherwise.

In this document, each of phrases such as "A or B," "at least one of A and B," "at least one of A or B," "A, B, or C," "at least one of A, B, and C," and "at least one of A, B, or C" may include any one of the items listed together in the corresponding phrase among these phrases or all possible combinations thereof. The terms such as "first," "second," "first," "second," "A," "B," "(a)," or "(b)" may simply be used to distinguish the corresponding component from another and do not limit the corresponding components in another aspect (e.g., importance or order).

In this document, when a certain (e.g., a first) component is described as being "connected," "coupled," or "joined or "coupled" or "connected" to another (e.g., a second) component with or without the terms "functionally" or "communicatively," this means that the certain component may be connected to another component directly (e.g., by wire), wirelessly, or through a third component.

According to various embodiments, each component (e.g., a module or a program) of the above-described components may include a single object or a plurality of objects, and some of the plurality of objects may be separately disposed in another component. According to various embodiments, one or more components or operations among the above-described corresponding components may be omitted, or one or more other components or operations may be added. Alternatively or additionally, the plurality of components (e.g., modules or programs) may be integrated into one component. In this case, the integrated component may perform one or more functions of each of the plurality of components identically or similarly to those performed by the corresponding component of the plurality of components before the integration. According to various embodiments, operations performed by modules, programs, or other components may be executed sequentially, in parallel, repeatedly, or heuristically, or one or more of the operations may be executed in a different order or omitted, or one or more other operations may be added.

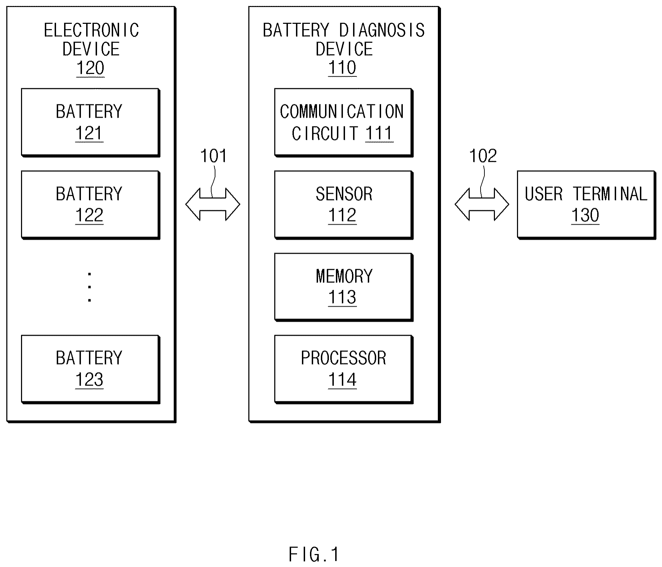

FIG. 1 is a block diagram of a battery diagnosis device according to one embodiment.

Referring to FIG. 1, a battery diagnosis device 110 may be connected to an electronic device 120 and a user terminal 130 by wire and/or wirelessly.

An operation of the battery diagnosis device 110, which will be described below, may be performed by a battery management system (BMS) in a vehicle and performed in various devices such as servers, clouds, chargers, and charger-dischargers.

According to one embodiment, a connection 101 between the battery diagnosis device 110 and the electronic device 120 may be a communication connection via a wired and/or wireless network. In one embodiment, the wired network may be based on local area network (LAN) communication or powerline communication. In addition, the wireless network may be based on a short-range communication network (e.g., Bluetooth, wireless fidelity (WiFi)) or infrared data association (IrDA)) or a telecommunication network (a cellular network, a fourth-generation (4G) network, or a fifth-generation (5G) network).

According to another embodiment, the connection 101 between the battery diagnosis device 110 and the electronic device 120 may be a connection via an inter-device communication method (e.g., a bus, a general purpose input and output (GPIO), a serial peripheral interface (SPI), or a mobile industry processor interface (MIPI)).

According to one embodiment, a connection 130 between the battery diagnosis device 110 and the electronic device 130 may be a communication connection via a wired and/or wireless network.

According to one embodiment, the electronic device 120 may be a mobile device (e.g., a mobile phone, a laptop computers, a smart phone, or a smart pad), an electric vehicle (e.g., an electric vehicle (EV), a hybrid EV (HEV), a plug-in HEV (PHEV), or a fuel cell EV (FCEV)), an ESS, or a battery swapping system (BSS).

According to one embodiment, the electronic device 120 may include one or more battery units 121, 122, and 123. Each of the one or more battery units 121, 122, and 123 may be a battery cell, a battery module, a battery pack, or a battery rack.

According to one embodiment, the user terminal 130 may be a mobile device (e.g., a mobile phone, a laptop computer, a smart phone, or a smart pad) or a personal computer (PC). According to one embodiment, information about a result of the estimation of the battery diagnosis device 110 may be provided to the user terminal.

According to one embodiment, the battery diagnosis device 110 may include a communication circuit 111, a sensor 112, a memory 113, and a processor 114. According to the embodiment, the battery diagnosis device 110 illustrated in FIG. 1 may further include at least one component (e.g., a display, an input device, or an output device) other than the components illustrated in FIG. 1 or include components from which at least one (e.g., a sensor 112) of the components illustrated in FIG. 1 is omitted. For example, when the battery diagnosis device 110 is implemented as an external electronic device separately from the electronic device 120, such as a server or a cloud, the battery diagnosis device 110 may acquire state information of the battery 121, 122, or 123 using the communication circuit 111, and the battery diagnosis device 110 may not include the sensor 112.

According to one embodiment, the communication circuit 111 may establish a wired communication channel and/or a wireless communication channel between the battery diagnosis device 110 and the electronic device 120 and/or the user terminal 130 and transmit and receive data with the electronic device 120 and/or the user terminal 130 through the established communication channel.

According to one embodiment, the sensor 112 may measure information about states of the battery units 121, 122, and 123 of the electronic device 120.

According to one embodiment, the communication circuit 111 and/or the sensor 112 may acquire time series data related to the states of the batteries 121, 122, and/or 123. In one embodiment, the time series data related to the states of the batteries 121, 122, and/or 123 may be data representing voltages, currents, resistances, and states of charge (SOC), states of health (SOH), and/or temperatures of the batteries 121, 122, and/or 123 over time. For example, the time series data may be univariate data on one of a plurality of variables (e.g., a voltage, a current, a resistance, a SOC, a SOH, and a temperature) related to the state of the battery. As another example, the time series data may be multivariate data on the plurality of variables related to the state of the battery.

According to one embodiment, the memory 113 may include a volatile memory and/or a non-volatile memory.

According to one embodiment, the memory 113 may store data used by at least one component (e.g., the processor 114) of the battery diagnosis device 110. For example, the data may include software (or commands related thereto), input data, or output data. In one embodiment, the command may allow the battery anomaly diagnosis device 101 to perform operations defined by the commands when executed by the processor 114.

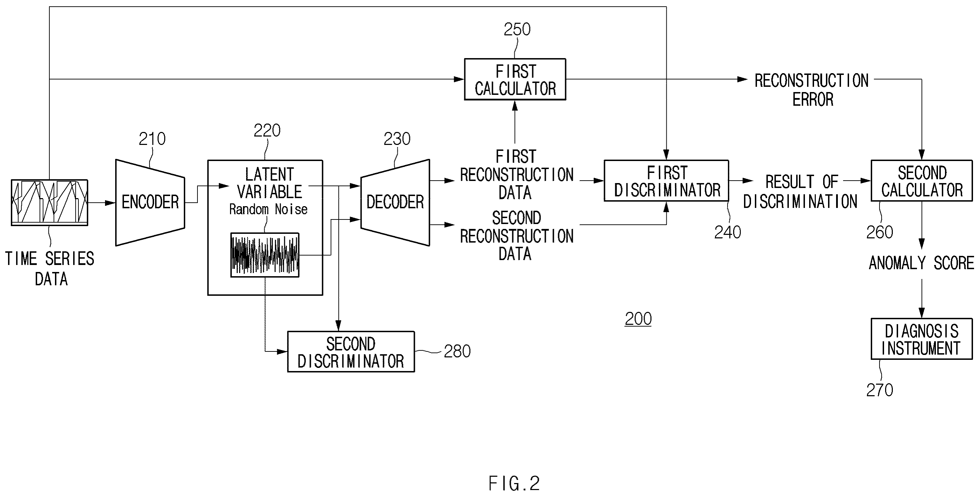

According to one embodiment, the memory 113 may receive the time series data related to the state of the battery 111, 112, or 113 and store a battery diagnosis system (e.g., a battery diagnosis system 200 in FIG. 2) for outputting an abnormal diagnosis result of the battery 111, 112, or 113.

According to one embodiment, the processor 114 may include a central processing unit, an application processor, a graphics processing unit, a neural processing unit (NPU), an image signal processor, a sensor hub processor, or a communication processor.

According to one embodiment, the processor 114 may control at least one another component (e.g., a hardware or software component) of the battery diagnosis device 110 connected to the processor 114 by executing software stored in the memory 113 and perform various data processing or calculations. For example, the processor 114 may learn the battery diagnosis system or perform the anomaly diagnoses of the batteries 111, 113, and/or 115 by executing the battery diagnosis system (e.g., the battery diagnosis system 200 in FIG. 2) stored in the memory 113.

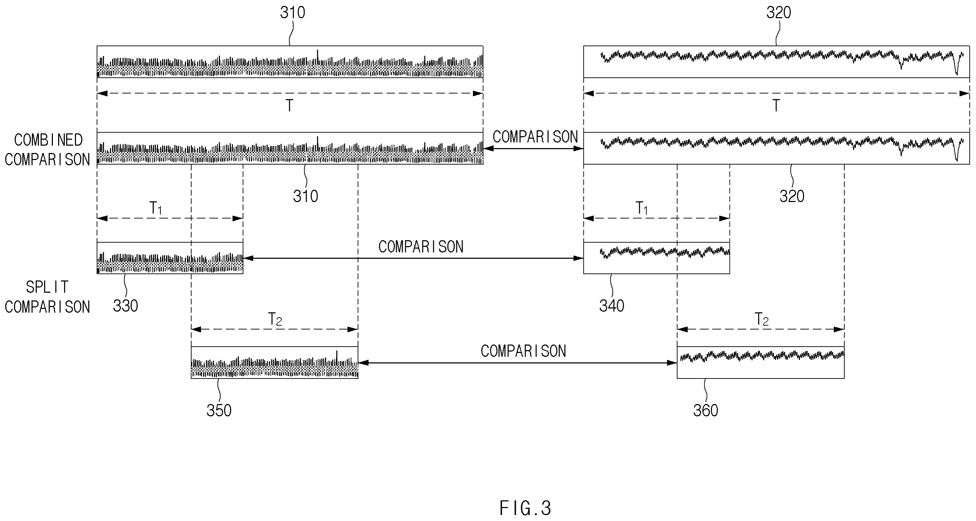

Hereinafter, the battery diagnosis system stored in the memory 113 may be described in detail with reference to FIGS. 2 and 3. Operations of components included in the battery diagnosis system, which will be described below, may be performed by various processing, calculations, or the like of the processor 114.

FIG. 2 is a view illustrating a battery diagnosis system according to one embodiment. FIG. 3 is a view for describing various examples in which the battery diagnosis system according to one embodiment calculates a reconstruction error.

Referring to FIG. 2, the battery diagnosis system 200 may include an encoder 210, a latent space 220, a decoder 230, a first discriminator 240, a first calculator 250, a second calculator 260, a diagnosis instrument 270, and/or a second discriminator 280.

According to one embodiment, some components (e.g., the encoder 210, the latent space 220, the decoder 230, the first discriminator 240, the first calculator 250, the second calculator 260 and the second discriminator 280) included in the battery diagnosis system 200 may be implemented through a time series anomaly detection using generative adversarial networks (TadGAN) model.

According to one embodiment, the encoder 210 may convert the time series data related to the state of the battery into a latent variable. Here, the latent variable may refer to data stored in the latent space 220 that is potentially shared between the time series data and the latent variable (i.e., between different domains).

According to one embodiment, the encoder 210 may operate to separate various types of features included in the time series data on the latent space 220. For example, when the time series data is the multivariate data on the plurality of variables related to the state of the battery, the encoder 210 may separate each of the plurality of variables included in the time series data and generate a plurality of latent variables corresponding to the plurality of variables. According to one embodiment, when converting the input data into the latent variable, the encoder 210 may be learned to allow similar features to be collected in the latent space 220 and non-similar features to be separated

According to one embodiment, the decoder 230 may convert data present in the latent space 220 into reconstruction data in a time domain.

According to one embodiment, the decoder 230 may convert the latent variable converted by the encoder 210 into first reconstruction data in the time domain. Here, since the latent variable corresponds to one of the plurality of variables included in the time series data, the first reconstruction data may be time series reconstruction data on the one variable.

According to one embodiment, the decoder 230 may convert random noise present in the latent space 220 into second reconstruction data in the time domain.

According to one embodiment, the decoder 230 may be learned to generate reconstruction data (e.g., the first reconstruction data) similar to original data (e.g., the time series data) based on a result of discrimination output by the first discriminator 240 and/or a reconstruction error output by the first calculator 250.

According to one embodiment, the first discriminator 240 may discriminate whether the data input to the first discriminator 240 is the time series data input to the encoder 210 or the original data is the first reconstruction data converted by the encoder 210 and the decoder 230. For example, the first discriminator 240 may use data combining the time series data with the first reconstruction data as reference data. The first discriminator 240 may compare the input data with the reference data and determine whether the input data is the time series data or the first reconstruction data. For example, the time series data input to the first discriminator 240 may be univariate time series data corresponding to one variable included in the first reconstruction data among the time series data input to the encoder 210. In this case, the first discriminator 240 may perform the discrimination on each of the plurality of first reconstruction data corresponding to each of the plurality of variables.

According to one embodiment, the first discriminator 240 may perform the discrimination based on a discrimination model learned to discriminate the time series data and the second reconstruction data converted from the random noise by the decoder 230.

According to one embodiment, the first discriminator 240 may discriminate between the time series data and the first reconstruction data and output a result of the discrimination. For example, the first discriminator 240 may output the similarity between the time series data and the first reconstruction data as a result of the discrimination. According to one embodiment, the first discriminator 240 may discriminate between the time series data and the first reconstruction data based on the discrimination model and output a result of the discrimination.

As described above, the battery diagnosis system 200 may generate the first reconstruction data similar to the time series data by repeating the first reconstruction data generation process by the encoder 210 and the decoder 230 and the discrimination process by the first discriminator 240 and discriminate the time series data and the first reconstruction data more precisely. In other words, adversarial learning may occur in the model, and it is possible to improve the quality of the reconstruction data generation.

According to one embodiment, the first calculator 250 may calculate the reconstruction error by comparing the time series data with the first reconstruction data. Here, the reconstruction error may represent a difference between the time series data and the first reconstruction data. For example, the time series data input to the first calculator 250 may be univariate time series data corresponding to one variable included in the first reconstruction data among the time series data input to the encoder 210. In this case, the first calculator 250 may calculate the reconstruction error for each of the plurality of first reconstruction data corresponding to each of the plurality of variables.

According to one embodiment, the first calculator 250 may calculate the reconstruction error by comparing the time series data with the first reconstruction data in the same time section. For example, the first calculator 250 may calculate the reconstruction error according to a combined comparison method of comparing the time series data with the first reconstruction data in the entire time section included in the time series data. As another example, the first calculator 250 may calculate the reconstruction error according to a split comparison method of comparing the time series data with the first reconstruction data in specified partial time sections of the entire time section included in the time series data. The combined comparison method and the split comparison method used by the first calculator 250 may be described in detail with reference to FIG. 3 below.

FIG. 3 illustrates original data 310, reconstruction data 320, some original data 330 and 350, and some reconstruction data 340 and 360.

According to one embodiment, the first calculator 250 may calculate the reconstruction error according to the combined comparison method of comparing the original data 310 with the reconstruction data 320 in the entire time section T of the original data 310 and the reconstruction data 320. According to the combined comparison method, the first calculator 250 may calculate the reconstruction error by calculating a difference between the original data 310 and the reconstruction data 320 in the entire time section T.

According to one embodiment, the first calculator 250 may calculate the reconstruction error according to the split comparison method of comparing the original data 330 or 350 with the reconstruction data 340 or 360 in partial time sections $T_1$ or $T_2$ of the original data 310 and the reconstruction data 320.

For example, the first calculator 250 may extract the first partial original data 330 corresponding to the first time section $T_1$ of the entire time section T from the original data 310 and extract the first partial reconstruction data 340 corresponding to the first time section $T_1$ from the reconstruction data 320. The first calculator 250 may calculate a first reconstruction error by comparing the first partial original data 330 with the first partial reconstruction data 340. As another example, the first calculator 250 may extract the second partial original data 350 corresponding to the second time section $T_2$ of the entire time section T from the original data 310 and extract the second partial reconstruction data 360 corresponding to the second time section $T_2$ from the reconstruction data 320. The first calculator 250 may calculate a second reconstruction error by comparing the second partial original data 350 with the second partial reconstruction data 360. According to one embodiment, the first calculator 250 may calculate the first reconstruction error or the second reconstruction error as the reconstruction error. According to another embodiment, the first calculator 250 may calculate the reconstruction error based on the first reconstruction error and the second reconstruction error. For example, the first calculator 250 may calculate maximum values, minimum values, or average values of the first reconstruction error and the second reconstruction error as the reconstruction error.

Referring back to FIG. 2, the second calculator 260 may calculate an anomaly score based on a result of the discrimination output by the first discriminator 240 and the reconstruction error output by the first calculator 250. According to one embodiment, the second calculator 260 may calculate the anomaly score corresponding to each of the plurality of variables included in the time series data.

According to one embodiment, the second calculator 260 may calculate the anomaly score based on Equation 1 or Equation 2 below.

[Equation 1]

$$Anomaly\ Score = \alpha \times Z_{reconstruction} + (1-\alpha) \times Z_{Cx}$$

[Equation 2]

$$Anomaly\ Score = \alpha \times Z_{reconstruction}) \times Z_{Cx}$$

(In Equation 1 and Equation 2, $\alpha$ denotes a weight, $Z_{reconstruction}$ denotes the reconstruction error, and $Z_{Cx}$ denotes a result of the discrimination.)

According to one embodiment, the diagnosis instrument 270 may diagnose the anomaly of the batteries 121, 122, and/or 123 based on the anomaly score output by the second calculator 260 and a critical value. For example, the diagnosis instrument 270 may compare the anomaly score with the critical value and diagnose the anomaly of the batteries 121, 122, and/or 123.

According to one embodiment, the diagnosis instrument 270 may increase the critical value, compare the anomaly score with the critical value, and diagnose the anomaly of the batteries 121, 122, and/or 123. For example, the diagnosis instrument 270 may repeat a process of increasing the critical value by a predetermined value (e.g., 0.5), comparing the increased critical value with the anomaly score, and performing anomaly diagnosis.

According to one embodiment, the diagnosis instrument 270 may identify whether the critical value is larger than or equal to a specified value. According to one embodiment, the diagnosis instrument 270 may determine an optimal critical value based on all critical values used when diagnosing the anomaly of the batteries 121, 122, and/or 123 when the critical value is larger than or equal to a specified value. For example, the diagnosis instrument 270 may calculate area under ROC curve (AUROC) values corresponding to all the critical values and determine a critical value corresponding to a maximum AUROC value among the calculated AUROC values to be the optimal critical value.

According to one embodiment, the second discriminator 280 may discriminate the performance of the encoder 210. According to one embodiment, the second discriminator 280 may discriminate the mapping performance of the encoder 210 based on the latent variable converted by the encoder 210 and the random noise on the latent space 220.

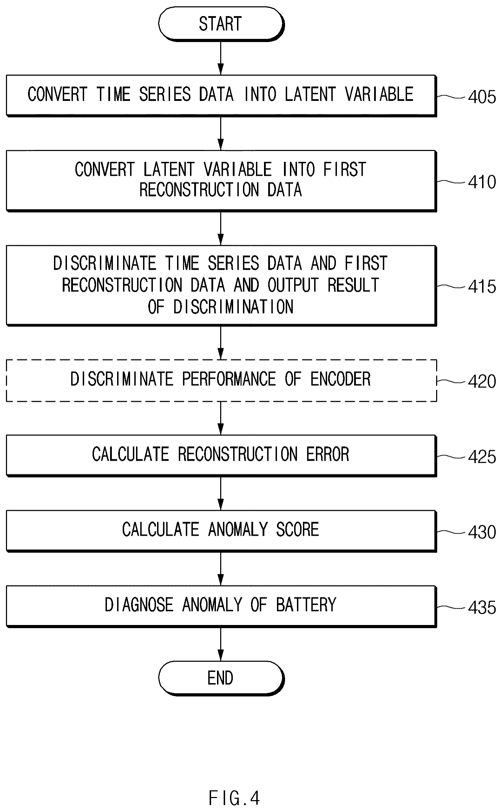

FIG. 4 is an operation flowchart of the battery diagnosis device according to one embodiment. FIG. 4 may be a description of the operation of the battery diagnosis device 110 in FIG. 1 and may be described using the configuration of FIG. 1.

The embodiment illustrated in FIG. 4 is only one embodiment, the order of operations according to various embodiments of the present invention may be different from that illustrated in FIG. 4, and some operations illustrated in FIG. 4 may be omitted, the order between the operations may be changed, or the operations may be merged. For example, operation 420 in FIG. 4 may be omitted.

Referring to FIG. 4, in operation 405, the battery diagnosis device 110 may convert the time series data on the state of the battery into the latent variable. Here, the latent variable may refer to data stored in the 220 that is potentially shared between the time series data and the latent variable (i.e., between different domains).

In operation 410, the battery diagnosis device 110 may convert the latent variable converted in operation 405 into the first reconstruction data in the time domain. Here, since the latent variable corresponds to one of the plurality of variables included in the time series data, the first reconstruction data may be time series reconstruction data on the one variable.

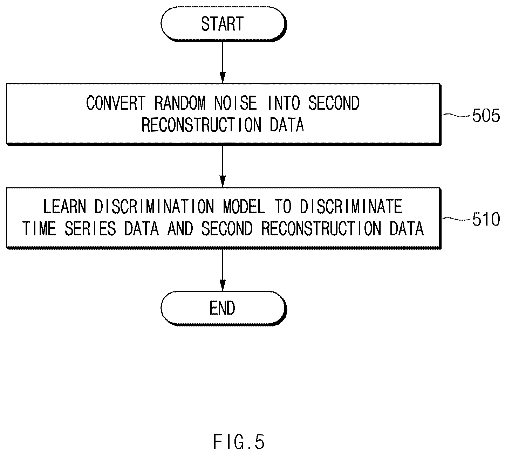

In operation 415, the battery diagnosis device 110 may discriminate the time series data and the first reconstruction data and output a result of the discrimination. For example, the battery diagnosis device 110 may output the similarity between the time series data and the first reconstruction data as a result of the discrimination. According to one embodiment, the battery diagnosis device 110 may discriminate between the time series data and the first reconstruction data based on the discrimination model and output a result of the discrimination. Here, the discrimination model may be described in detail with reference to FIG. 5 to be described below. For example, the time series data used in operation 415 may be univariate time series data corresponding to one variable included in the first reconstructed data among the time series data used in operation 405. In this case, the battery diagnosis device 110 may perform the discrimination on each of the plurality of first reconstruction data corresponding to each of the plurality of variables.

In operation 420, the battery diagnosis device 110 may discriminate the performance of the encoder 210. According to one embodiment, the battery diagnosis device 110 may discriminate the mapping performance of the encoder 210 based on the latent variable converted in operation 405 and the random noise on the latent space 220.

In operation 425, the battery diagnosis device 110 may calculate the reconstruction error. According to one embodiment, the battery diagnosis device 110 may calculate the reconstruction error by comparing the time series data with the first reconstruction data converted in operation 410. Here, the reconstruction error may represent a difference between the time series data and the first reconstruction data. For example, the time series data used in operation 425 may be univariate time series data corresponding to one variable included in the first reconstructed data among the time series data used in operation 405. In this case, the battery diagnosis device 110 may calculate the reconstruction error for each of the plurality of first reconstruction data corresponding to each of the plurality of variables.

According to one embodiment, the battery diagnosis device 110 may calculate the reconstruction error by comparing the time series data with the first reconstruction data in the same time section. For example, the battery diagnosis device 110 may calculate the reconstruction error according to the combined comparison method of comparing the time series data with the first reconstruction data in the entire time section included in the time series data. As another example, the battery diagnosis device 110 may calculate the reconstruction error according to the split comparison method of comparing the time series data with the first reconstruction data in specified partial time sections of the entire time section included in the time series data.

In operation 430, the battery diagnosis device 110 may calculate the anomaly score based on a result of the discrimination calculated in operation 415 and the reconstruction error calculated in operation 425. According to one embodiment, the battery diagnosis device 110 may calculate the anomaly score corresponding to each of the plurality of variables included in the time series data.

According to one embodiment, the battery diagnosis device 110 may calculate the anomaly score based on Equation 1 or Equation 2.

In operation 435, the battery diagnosis device 110 may diagnose the anomaly of the batteries 121, 122, and/or 123 based on the anomaly score and the critical value calculated in operation 430. For example, the battery diagnosis device 110 may compare the anomaly score with the critical value and diagnose the anomaly of the batteries 121, 122, and/or 123.

FIG. 5 is an operation flowchart of the battery diagnosis device according to one embodiment. FIG. 5 may be a description of the operation of the battery diagnosis device 110 in FIG. 1 and may be described using the configuration of FIG. 1.

The embodiment illustrated in FIG. 5 is only one embodiment, the order of operations according to various embodiments of the present invention may be different from that illustrated in FIG. 5, and some operations illustrated in FIG. 5 may be omitted, the order between the operations may be changed, or the operations may be merged.

Referring to FIG. 5, in operation 505, the battery diagnosis device 110 may convert the random noise present in the latent space 220 into the second reconstruction data in the time domain.

In operation 510, the battery diagnosis device 110 may learn the discrimination model to discriminate between the time series data and the second reconstruction data converted in operation 510.

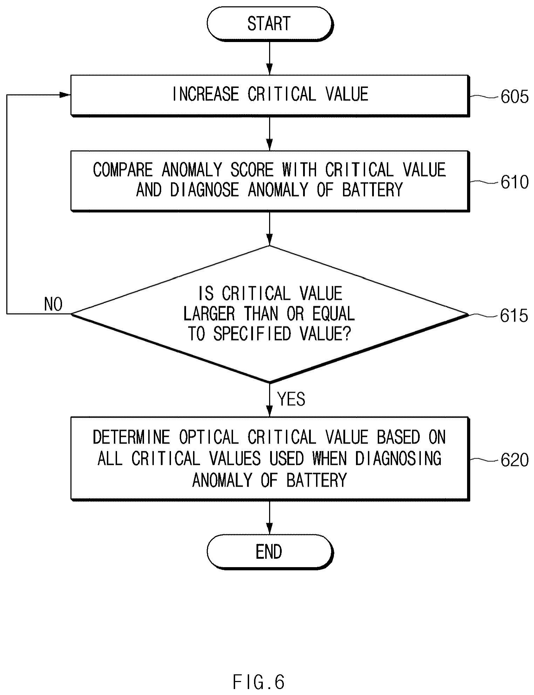

FIG. 6 is an operation flowchart of the battery diagnosis device according to one embodiment. FIG. 6 may be a description of the operation of the battery diagnosis device 110 in FIG. 1 and may be described using the configuration of FIG. 1.

The embodiment illustrated in FIG. 6 is only one embodiment, the order of operations according to various embodiments of the present invention may be different from that illustrated in FIG. 6, and some operations illustrated in FIG. 6 may be omitted, the order between the operations may be changed, or the operations may be merged.

Referring to FIG. 6, in operation 605, the battery diagnosis device 110 may increase the critical value. For example, the battery diagnosis device 110 may increase the critical value by the predetermined value (e.g., 0.5).

In operation 610, the battery diagnosis device 110 may compare the anomaly score with the critical value and diagnose the anomaly of the batteries 121, 122, and/or 123.

In operation 615, the battery diagnosis device 110 may identify whether the critical value increased in operation 605 is larger than or equal to the specified value.

When the critical value is identified as being smaller than the specified value ("NO") in operation 615, the battery diagnosis device 110 may re-perform operation 605.

When the critical value is identified as being larger than or equal to the specified value ("YES") in operation 615, in operation 620, the battery diagnosis device 110 may the optimal critical value based on all critical values used when diagnosing the anomaly of the batteries 121, 122, and/or 123. For example, the battery diagnosis device 110 may calculate the AUROC values corresponding to all the critical values and determine the critical value corresponding to the maximum AUROC value among the calculated AUROC values to be the optimal critical value.

The terms such as "comprise," "constitute," or "have" described above mean that the corresponding component may be inherent unless otherwise stated, and thus should be construed as further including another component rather than excluding another component. All terms including technical or scientific terms have the same meaning as commonly understood by those skilled in the art to which the embodiments disclosed herein pertain unless defined otherwise. Commonly used terms, such as terms defined in a dictionary, should be construed as consistent with the contextual meaning of the related art and are not construed in an ideal or excessively formal meaning unless explicitly defined herein.

**Claims**

1. A battery diagnosis device comprising:

   an encoder configured to convert time series data on a state of a battery into a latent variable;
   a decoder configured to convert the latent variable into first reconstruction data in a time domain;

a first discriminator configured to discriminate the time series data with the first reconstruction data and output a result of the discrimination;

a first calculator configured to compare the time series data with the first reconstruction data and calculate a reconstruction error;

a second calculator configured to calculate an anomaly score based on a result of the discrimination and the reconstruction error; and

a diagnosis instrument configured to diagnose the anomaly of the battery based on the anomaly score and a critical value.

2. The battery diagnosis device of claim 1, further comprising a second discriminator configured to discriminate the performance of the encoder based on the latent variable and random noise on a latent space.

3. The battery diagnosis device of claim 1, wherein the decoder converts the random noise on the latent space into second reconstruction data in the time domain, and

the first discriminator outputs a result of the discrimination based on a discrimination model learned to discriminate the time series data and the second reconstruction data.

4. The battery diagnosis device of claim 1, wherein the first calculator calculates the reconstruction error according to a combined comparison method of comparing the time series data with the first reconstruction data in the entire time section included in the time series data.

5. The battery diagnosis device of claim 1, wherein the first calculator calculates the reconstruction error according to a split comparison method of comparing the time series data with the first reconstruction data in a specified partial time section of the entire time section included in the time series data.

6. The battery diagnosis device of claim 1, wherein the second calculator calculates the anomaly score based on Equation 1 below,

[Equation 1]

$$Anomaly\ Score = \alpha \times Z_{reconstruction} + (1-\alpha) \times Z_{Cx}$$

(in Equation 1, $\alpha$ denotes a weight, $Z_{reconstruction}$ denotes the reconstruction error, and $Z_{Cx}$ denotes a result of the discrimination.).

7. The battery diagnosis device of claim 1, wherein the second calculator calculates the anomaly score based on Equation 2 below,

[Equation 2]

$$Anomaly\ Score = \alpha \times Z_{reconstruction}) \times Z_{Cx}$$

(in Equation 2, $\alpha$ denotes a weight, $Z_{reconstruction}$ denotes the reconstruction error, and $Z_{Cx}$ denotes a result of the discrimination.).

8. The battery diagnosis device of claim 1, wherein the diagnosis instrument is configured to:

increase the critical value, compare the anomaly score with the critical value, and diagnose the anomaly of the battery; and

determine an optimal critical value based on all critical values used when diagnosing the anomaly of the battery when the critical value is larger than or equal to a specified value.

9. The battery diagnosis device of claim 8, wherein the diagnosis instrument is configured to:

calculate area under ROC curve (AUROC) values corresponding to the all critical values; and

determine a critical value corresponding to a maximum AUROC value among the AUROC values to be an optimal critical value.

**10.** A battery diagnosis method comprising:

an operation of converting time series data on a state of a battery into a latent variable;
an operation of converting the latent variable into first reconstruction data in a time domain;
an operation of discriminating the time series data with the first reconstruction data and calculating a result of the discrimination;
an operation of comparing the time series data with the first reconstruction data and calculating a reconstruction error;
an operation of calculating an anomaly score based on a result of the discrimination and the reconstruction error; and
an operation of diagnosing the anomaly of the battery based on the anomaly score and a critical value.

**11.** The battery diagnosis method of claim 10, further comprising an operation of converting random noise on a latent space into second reconstruction data in a time domain,
wherein the operation of discriminating a result of the discrimination includes an operation of calculating a result of the discrimination based on a discrimination model learned to discriminate the time series data and the second reconstruction data.

**12.** The battery diagnosis method of claim 10, wherein the operation of calculating the reconstruction error includes an operation of calculating the reconstruction error according to a combined comparison method of comparing the time series data with the first reconstruction data in the entire time section included in the time series data.

**13.** The battery diagnosis method of claim 10, wherein the operation of calculating the reconstruction error includes an operation of calculating the reconstruction error according to a split comparison method of comparing the time series data with the first reconstruction data in a specified partial time section of the entire time section included in the time series data.

**14.** The battery diagnosis method of claim 10, further comprising: an operation of increasing the critical value, comparing the anomaly score with the critical value, and diagnosing the anomaly of the battery; and
an operation of determining an optimal critical value based on all critical values used when diagnosing the anomaly of the battery when the critical value is larger than or equal to a specified value.

**15.** The battery diagnosis method of claim 14, wherein the operation of determining the optimal critical value includes:

an operation of calculating area under ROC curve (AUROC) values corresponding to the all critical values; and
an operation of determining a critical value corresponding to a maximum AUROC value among the AUROC values to be an optimal critical value.

ELECTRONIC
DEVICE
120

BATTERY
121

BATTERY
122

⋮

BATTERY
123

101

BATTERY DIAGNOSIS
DEVICE
110

COMMUNICATION
CIRCUIT 111

SENSOR
112

MEMORY
113

PROCESSOR
114

102

USER TERMINAL
130

FIG.1

FIG.2

FIG.3

START

CONVERT TIME SERIES DATA INTO LATENT VARIABLE — 405

CONVERT LATENT VARIABLE INTO FIRST
RECONSTRUCTION DATA — 410

DISCRIMINATE TIME SERIES DATA AND FIRST
RECONSTRUCTION DATA AND OUTPUT RESULT
OF DISCRIMINATION — 415

DISCRIMINATE PERFORMANCE OF ENCODER — 420

CALCULATE RECONSTRUCTION ERROR — 425

CALCULATE ANOMALY SCORE — 430

DIAGNOSE ANOMALY OF BATTERY — 435

END

FIG.4

FIG.5

START

INCREASE CRITICAL VALUE — 605

COMPARE ANOMALY SCORE WITH CRITICAL VALUE
AND DIAGNOSE ANOMALY OF BATTERY — 610

IS CRITICAL VALUE
LARGER THAN OR EQUAL
TO SPECIFIED VALUE? — 615

NO

YES

DETERMINE OPTICAL CRITICAL VALUE BASED ON
ALL CRITICAL VALUES USED WHEN DIAGNOSING
ANOMALY OF BATTERY — 620

END

FIG.6

**EP 4 715 405 A1**

## INTERNATIONAL SEARCH REPORT

| International application No. |
|---|
| **PCT/KR2023/017754** |

| A. | CLASSIFICATION OF SUBJECT MATTER |
|---|---|

**G01R 31/367**(2019.01)i; **G01R 31/36**(2006.01)i; **G01R 31/392**(2019.01)i; **G01R 31/396**(2019.01)i; **G01R 31/52**(2020.01)i

According to International Patent Classification (IPC) or to both national classification and IPC

| B. | FIELDS SEARCHED |
|---|---|

Minimum documentation searched (classification system followed by classification symbols)

G01R 31/367(2019.01); G01R 31/36(2006.01); G01R 31/382(2019.01); G01R 31/396(2019.01); G06N 3/04(2006.01); G06N 3/08(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 시계열(time series), 전지(battery), 잠재 변수(latent variable), 재구성 오차 (reconstruction error), 이상점수(anomaly score), 임계값(threshold value)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | KR 10-2023-0057894 A (LG ENERGY SOLUTION, LTD.) 02 May 2023 (2023-05-02)<br>See claims 1-3. | 1-15 |
| A | KR 10-2023-0069592 A (LG ENERGY SOLUTION, LTD.) 19 May 2023 (2023-05-19)<br>See entire document. | 1-15 |
| A | KR 10-2023-0087137 A (LG ENERGY SOLUTION, LTD.) 16 June 2023 (2023-06-16)<br>See claims 1-7. | 1-15 |
| A | KR 10-2022-0100442 A (LG ENERGY SOLUTION, LTD.) 15 July 2022 (2022-07-15)<br>See entire document. | 1-15 |
| A | US 2022-0390524 A1 (MITSUBISHI ELECTRIC CORPORATION) 08 December 2022 (2022-12-08)<br>See entire document. | 1-15 |

☐ Further documents are listed in the continuation of Box C.　　☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **18 March 2024** | **18 March 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2023/017754**

| Patent document cited in search report | | | Publication date (day/month/year) | Patent family member(s) | | | Publication date (day/month/year) |
|---|---|---|---|---|---|---|---|
| KR | 10-2023-0057894 | A | 02 May 2023 | CN | 116829966 | A | 29 September 2023 |
| | | | | EP | 4321884 | A1 | 14 February 2024 |
| | | | | JP | 2024-500893 | A | 10 January 2024 |
| | | | | WO | 2023-068899 | A1 | 27 April 2023 |
| KR | 10-2023-0069592 | A | 19 May 2023 | None | | | |
| KR | 10-2023-0087137 | A | 16 June 2023 | CN | 116829967 | A | 29 September 2023 |
| | | | | EP | 4246159 | A1 | 20 September 2023 |
| | | | | JP | 2024-502248 | A | 18 January 2024 |
| | | | | WO | 2023-106729 | A1 | 15 June 2023 |
| KR | 10-2022-0100442 | A | 15 July 2022 | CN | 116324453 | A | 23 June 2023 |
| | | | | EP | 4202458 | A1 | 28 June 2023 |
| | | | | JP | 2023-541139 | A | 28 September 2023 |
| | | | | US | 2023-0366938 | A1 | 16 November 2023 |
| | | | | WO | 2022-149890 | A1 | 14 July 2022 |
| US | 2022-0390524 | A1 | 08 December 2022 | JP | 6818947 | B1 | 27 January 2021 |
| | | | | WO | 2021-171333 | A1 | 02 September 2021 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230080445